# EUROPÄISCHE PATENTSCHRIFT

(11) **EP 1 905 655 B1**
(45) Veröffentlichungstag und Bekanntmachung des Hinweises auf die Patenterteilung: **10.11.2010**
(21) Anmeldenummer: 07018464.3
(22) Anmeldetag: 20.09.2007
(51) Int. Cl.: B60R 16/02, H03K 17/955

(54) **Sensoreinrichtung für Fahrzeuge**
Sensor device for vehicles
Dispositif de capteur pour véhicules

(30) Priorität: 29.09.2006 DE 102006046407
(43) Veröffentlichungstag der Anmeldung: 02.04.2008
(73) Patentinhaber: Huf Hülsbeck & Fürst GmbH & Co. KG, 42551 Velbert (DE)
(72) Erfinder: van Gastel, Peter, 42699 Solingen (DE); Lindic, Iko, 45149 Essen (DE)
(74) Vertreter: Eggers, Thomas Peter

(56) Entgegenhaltungen:
- DE-A1- 19 856 408
- DE-C1- 19 501 232

## Beschreibung

Die vorliegende Erfindung betrifft eine Sensoreinrichtung für Fahrzeuge, insbesondere zum Einsatz in Bedieneinrichtungen von Kraftfahrzeugen, mit einer Mehrzahl von Sensorabschnitten, welche an Bedienstellen des Fahrzeuges angeordnet sind. Daneben betrifft die Erfindung ein Verfahren zum Erkennen von Signaleingaben an Fahrzeugen. Die Erfindung findet insbesondere Anwendung im Automobil-Bereich.

Im Stand der Technik ist es bekannt, Kraftfahrzeugtürschlösser mit kapazitiven Sensoren zu versehen, die mit Auswertungsschaltungen verbunden sind. Je nach Betätigungsreihenfolge bzw. Annäherung an die Sensoren, kann ein Bediener unterschiedliche Funktionen auslösen. Nachteilig bei den bekannten Systemen ist jedoch, dass diese, insbesondere bei der Verdrahtung, einen hohen Herstellungsaufwand und damit hohe Herstellungskosten aufweisen. Zudem lässt die Zuverlässigkeit der Eingabeerkennung bei manchen Systemen zu wünschen übrig.

In der DE 19501232 C1 ist ein Verfahren und eine Schaltungsanordnung für einen Kapazitiven, digitalen Ausnäherungsschalter offenbart.

Aus der gattungsbildenden DE 19856408 A1 ist ein kapazitives Sensorsystem für berührungslos durch elektrische, nicht leitende Materialien hindurch arbeitende bzw. bedienbare Sensoranordnungen und berührungssensitive Anzeigesysteme bekannt.

Hiervon ausgehend ist es Aufgabe der vorliegenden Erfindung eine Vorrichtung und ein Verfahren anzugeben, die gegenüber dem bekannten Stand der Technik einen besonders einfachen Aufbau aufweisen, zuverlässig arbeiten und kostengünstig herzustellen bzw. auszuführen sind.

Diese Aufgaben werden mit einer Vorrichtung gemäß den Merkmalen des Patentanspruchs 1 sowie einem Verfahren gemäß den Merkmalen des Patentanspruchs 9 gelöst. Weitere vorteilhafte Ausgestaltungen der Vorrichtung und des Verfahrens sind in den abhängig formulierten Patentansprüchen angegeben. Es ist darauf hinzuweisen, daß die in den Unteransprüchen einzeln aufgeführten Merkmale in beliebiger technologisch sinnvoller Weise miteinander kombiniert werden können und weitere Ausgestaltungen der Erfindung definieren.

Die erfindungsgemäße Vorrichtung ist eine Sensoreinrichtung für Fahrzeuge, insbesondere zum Einsatz in Bedieneinrichtungen von Kraftfahrzeugen. Sie ist mit einer Mehrzahl von Sensorabschnitten ausgestattet, welche an Bedienstellen des Fahrzeuges angeordnet sind, wobei die Sensorabschnitte über eine elektrische Reihenschaltung miteinander verbunden sind und in dieser Reihenschaltung zusätzlich wenigstens zwei voneinander getrennte kapazitive Bauteile angeordnet sind, zwischen denen sich wenigstens ein Sensorabschnitt befindet. Bevorzugt befinden sich mehrere oder sogar alle Sensorabschnitte zwischen diesen kapazitiven Bauteilen.

Unter Bedienstellen sind hier verschiedenste Stellen eines Fahrzeuges zu verstehen, an denen Bedienvorgänge mittels Bedieneinrichtungen vorgenommen werden können. So bildet etwa der Betätigungsgriff einer Heckklappe eine Bedieneinrichtung, die gleichzeitig eine Bedienstelle am Heck eines Fahrzeuges darstellt. Ähnliches gilt auch für Türverriegelung oder die Bedienelemente von Klimaanlagen, um nur einige beispielhaft anzuführen. Die Sensorabschnitte stellen den Bestandteil der Sensoreinrichtung dar, der mit einem Bediener zuerst in Wechselwirkung tritt, um dann weitere Funktionalitäten innerhalb der Sensoreinrichtung zu bewirken. Die Sensorabschnitte können selbst als selbstständig funktionierende Messwertaufnehmer bzw. Messfühler ausgebildet sein, die zusammen dann den gewünschten Sensor (insbesondere (berührungsfrei arbeitenden) Bewegungssensor bzw. Bewegungsrichtungssensor) bilden.

Generell kann die Erfindung an allen Arten von Fahrzeugen, wie etwa Land-, Luft- oder Wasserfahrzeugen, eingesetzt werden. Dabei kann mittels der erfindungsgemäßen Sensoreinrichtung eine Vielzahl von Funktionen am oder im Fahrzeug gesteuert werden. Als Beispiele seien hier Funktionen der Schließanlagen, wie etwa ein Öffnen oder Entriegeln einer Fahrzeugtür bzw. -klappe, die Bedienung einer motorisch angetriebenen Sitzanlage oder Steuerungen von Klimaanlagen erwähnt. Die Sensoreinrichtung kann dazu beispielsweise in einem Türgriff angeordnet sein und dazu dienen, die Funktion von Öffnungs- und Schließsystemen zu steuern. Dies kann etwa durch kapazitive Sensorabschnitte geschehen, die eine Kapazitätsänderung aufgrund der Annäherung einer menschlichen Hand an den Türgriff und die Sensoreinrichtung registrieren. Eine mögliche Bedieneinrichtung mit der die Erfindung zusammen nutzbar ist, stellt bei Fahrzeugtüren ein Türaußen- bzw. Türinnengriff dar.

Je nach Bedieneinrichtung kann die Sensoreinrichtung etwa im Fahrzeuginnenraum auch Druck- oder Berührungsschalter als Sensorabschnitte aufweisen, über die eine Eingabe durch einen Bediener erfasst wird. Die Sensoreinrichtung weist dazu eine Mehrzahl von Sensorabschnitten auf, welche in einer Reihenschaltung durch einen elektrischen Leiter miteinander verbunden sind. Zusätzlich sind noch wenigstens zwei kapazitive Bauteile in der Reihenschaltung angeordnet, zwischen denen sich wenigstens ein Sensorabschnitt befindet. Besonders vorteilhaft ist es dabei, wenn sich möglichst viele Sensorabschnitte zwischen den kapazitiven Bauteilen befinden, da dann eine Veränderung der elektrischen Kapazitäten der Bauteile bei einer Betätigung der Sensorabschnitte quantitativ besonders deutlich und damit gut meßbar ist. Es ist aber auch durchaus möglich nur einen Teil der vorhandenen Sensorabschnitte zwischen den kapazitiven Bauteilen anzuordnen, was dann bei einer nachfolgenden Auswertung zu berücksichtigen ist.

Berührt nun ein Bediener einen Sensorabschnitt, so verändert er die elektrischen Eigenschaften der Reihenschaltung. Ein Parameter an dem sich diese Veränderung ablesen lässt, ist das etwa das Dämpfungsverhalten der kapazitiven Bauteile. Die kapazitiven Bauteile stehen in einer wechselseitigen Abhängigkeit zueinander, woraus sich je nach betätigtem Sensorabschnitt ganz bestimmte Dämpfungseigenschaften bzw. Kapazitäten ergeben. Wird dann ein Sensorabschnitt von einem Bediener berührt bzw. betätigt, der nah bei einem ersten kapazitiven Bauteil und weit entfernt von einem zweiten kapazitiven Bauteil liegt, so erfährt das erste Bauteil eine höhere Dämpfung und das zweite Bauteil eine geringe Dämpfung. Der umgekehrte Fall tritt ein, wenn ein Sensorabschnitt nahe dem zweiten kapazitiven Bauteil berührt bzw. betätigt wird. Aus dem Verhalten der Reihenschaltung kann damit in zuverlässiger und einfacher Weise die Art der erfolgten Eingabe ermittelt werden.

Eine andere bevorzugte Ausführungsform der Erfindung sieht vor, daß die Sensoreinrichtung an eine Steuerungseinrichtung, insbesondere eine Auswerteeinrichtung, angeschlossen ist. Häufig sind in Fahrzeugen bereits Steuerungseinrichtungen vorhanden, die mit geringen Modifikationen für derartige Aufgaben nutzbar sind. Ansonsten kann auch eine separate und einfache Auswertungsschaltung Steuerungseinrichtung verwendet werden, um den betätigten Sensorabschnitt anhand der Parameter der in der Sensoreinrichtung verwendeten kapazitiven Bauteile zu identifizieren. Die Auswerteeinrichtung wirkt mit mindestens zwei kapazitiven Bauteilen zusammen.

Besonders bevorzugt ist eine Vorrichtung, bei der die Sensorabschnitte als Elektroden ausgebildet sind. Einfache metallische Kontaktflächen, reichen hierbei bereits aus, um einen elektrischen Kontakt zwischen einem Bediener und der Sensoreinrichtung herzustellen. Bei besonders sensitiven Ausführungsformen kann es bereits ausreichend sein, die Hand in die Nähe einer Kontaktfläche zu bewegen, um bereits eine meßbar große Veränderung der elektrischen Kapazitäten der kapazitiven Bauteile zu bewirken. Darüber hinaus sind aber auch andere geeignete Mittel denkbar, um eine Kapazitätsänderung herbeizuführen und damit eine Eingabe an die Sensoreinrichtung vorzunehmen.

Ist es gefordert, daß die Vorrichtung mit besonders hoher Zuverlässigkeit die Bedieneingaben eines Bedieners erkennt, so ist dies erreichbar, indem zwischen den Sensorabschnitten wenigsten ein elektrischer Widerstand angeordnet ist. Zwar hat jeder die Sensorabschnitte verbindende Leiter, wie beispielsweise Kabel oder Stanzgitter, einen Widerstand, dieser kann jedoch unter Umständen so gering sein, dass eine Messung einer Kapazitäts- oder Dämpfungsänderung, insbesondere bei der Betätigung von zwei unmittelbar benachbarten Sensorabschnitten, schwierig ist. Wesentlich besser messbar sind hingegen Kapazitäts- oder Dämpfungsänderungen bei dazwischen angeordneten Widerständen, da hierbei wesentlich deutlichere Veränderungen der Eigenschaften der kapazitiven Bauteil zu beobachten sind. Bevorzugt liegt der Widerstand in einem Bereich von 1.000 bis 100.000 Ohm [Ω].

Weiterhin wird vorgeschlagen eine erfindungsgemäße Vorrichtung zu verwenden, bei der die kapazitiven Bauteile Kondensatoren sind. Hierbei kann auf preiswerte, erprobte und in großer Vielfalt verfügbare Bauteil zurückgegriffen werden. Grundsätzlich lassen sich hierbei alle elektrischen Bauteile verwenden, die eine elektrische Kapazität aufweisen, da diese als Parameter erfaßt und ausgewertet wird. Bei Bedarf können diese Bauteile dann auch noch andere Funktionen ausführen. Bevorzugt liegt die Kapazität in einem Bereich von 1 bis 300 Nanofarad [nF].

Eine ganz besonders bevorzugte Ausgestaltung der Erfindung sieht vor, dass die Steuerungseinrichtung jeweils mit beiden elektrischen Anschlußstellen der verwendeten kapazitiven Bauteile verbunden ist. Die Steuerungseinrichtung bzw. Auswerteeinrichtung, kann so die für die Ermittlung der betätigten Sensorabschnitte erforderlichen Parameter der kapazitiven Bauteile bzw. Kondensatoren, wie etwa die Dämpfung oder Kapazität, ermitteln. Eine Auswerteeinrichtung bildet dabei eine spezielle Ausbildung einer Steuerungseinrichtung, die speziell für die Erkennung von Bedienvorgängen ausgebildet ist. Im Gegensatz dazu können andere Steuerungseinrichtungen, insbesondere programmierbar, zusätzlich noch andere Steuerungsaufgaben übernehmen. So kann mit einer Auswerteeinrichtung bestimmt werden, welche Sensorabschnitte in welcher Reihenfolge bzw. Richtung und mit welcher Geschwindigkeit bedient werden. Dies kann dann dazu verwendet werden, um zwischen verschiedenen Befehlen zu differenzieren, welche in Folge des Bedienvorganges zu erkennen bzw. auszuführen sind.

Zur Gewährleistung einer besonders komfortablen Bedienung eines Fahrzeuges, kann die Sensoreinrichtung im Bereich eines Schließsystems eines Fahrzeuges angeordnet sein. Dort können dann mit Hilfe der Sensorabschnitte Öffnung- und Schließ- sowie Ent- und Verriegelungsvorgänge gesteuert werden. Aber auch die Eingabe eines Zugangscodes über die Sensorabschnitte oder die Erfassung einer Bewegung einer Bedienerhand über mehrere Sensorabschnitte sind damit möglich.

Eine andere besonders vorteilhafte Anwendung der Erfindung sieht den Einsatz der Sensoreinrichtung in einem Fahrzeuginnenraum an einer Bedienstelle von Interieurfunktionen vor. Diese Funktionen können beispielsweise zur Bedienung von Klimasteuergeräten, Niveauregulierungen oder Sitzsteuerungen dienen. Ganz besonders ist die Sensoreinrichtung dazu geeignet, wenn sie eine Vielzahl von Sensorabschnitten und damit sehr viele fein abgestufte Schaltstufen besitzt.

Das erfindungsgemäße Verfahren zum Erkennen von Signaleingaben an Fahrzeugen auf das sich die Erfindung ferner richtet, umfaßt zumindest folgende Schritte:
a) Herstellung einer wechselseitigen Abhängigkeit zwischen zwei kapazitiven Bauteilen mittels Sensorabschnitten;
b) Überwachung wenigstens eines Parameters der in Abhängigkeit stehenden kapazitiven Bauteile mittels einer Steuerungseinrichtung; und
c) Ermittlung einer Signaleingabe aus jeweils zwei in wechselseitiger Abhängigkeit stehenden Parametern, wobei bestimmten Parameterkombinationen oder Gruppen von Parameterkombinationen jeweils definierte Signaleingaben zugewiesen werden.

Auch hierbei ergeben sich wieder, die zuvor erwähnten Vorteile, indem mit der vorliegenden Erfindung eine besonders einfache und zuverlässige Erkennung von Eingaben durch Bediener möglich ist.

Im ersten Schritt des Verfahrens wird eine wechselseitige Abhängigkeit zwischen den kapazitiven Bauteilen hergestellt. Dies geschieht z. B. durch eine Reihenschaltung von kapazitiven Bauteilen und Sensorabschnitten. Handelt es sich bei den kapazitiven Bauteilen um Kondensatoren und bei den Sensorabschnitten um Elektroden, so weisen die Kondensatoren eine bestimmte elektrische Kapazität auf. Berührt nun eine Person eine der Elektroden oder gelangt zumindest in deren Nähe, so werden hierdurch die Kapazitäten der Kondensatoren verändert. Aufgrund der Reihenschaltung der beiden Kondensatoren geschieht diese Kapazitätsveränderung nicht willkürlich, sondern nach einer durch den Aufbau der Reihenschaltung vorgegebenen Gesetzmäßigkeit. So bewirkt die Veränderung der Kapazität eines Kondensators immer zwangsweise auch die Veränderung der Kapazität des zweiten Kondensators. Diese beeinflussen sich damit gegenseitig und stehend in einer wechselseitigen Abhängigkeit.

Im nächsten Schritt des Verfahrens wird ein bestimmter Parameter der kapazitiven Bauteile überwacht. Diese Überwachung kann mittels einer Steuerungseinrichtung, insbesondere mittels einer Auswerteeinheit überwacht werden. Bei dem zuvor bereits beschriebenen Beispiel mit zwei Kondensatoren, wären die zu überwachenden Parameter die elektrischen Kapazitäten der Kondensatoren.

Im dritten Schritt schließlich, wird aus den bekannten Kapazitäten und der ebenfalls bekannten Abhängigkeit der Kapazitäten und von der Betätigung der Sensorabschnitte der betätigte Sensorabschnitt ermittelt. Sind etwa fünf Elektroden vorhanden und kennt man die Kapazitäten, welche die Kondensatoren jeweils bei der Betätigung einer der Elektroden aufweisen, kann umgekehrt aus den ermittelten Kapazitäten auf die betätigte Elektrode rückgeschlossen werden. In der Praxis ist es dazu sinnvoll anstelle einzelner diskreter Kapazitäten jeweils einen Wertebereich anzugeben, das dann einer betätigten Elektrode zugeordnet ist. Da die Parameter in einer wechselseitigen Abhängigkeit zueinander stehen, ist es auch möglich Parameterkombinationen für bestimmte Elektroden, beispielsweise mit Kapazitätswerten für den ersten und den zweiten Kondensator vorzugeben, bei deren auftreten sicher ist, daß die zugehörige Elektrode bedient worden ist. Neben einzelnen diskreten Kapazitätswerten können auch bei den Parameterkombinationen jeweils Wertebereich angegeben werden, um die in der Praxis auftretenden Toleranzen auszugleichen. Neben der Erkennung von Bedienvorgängen einzelner Elektroden, ist es mit der Erfindung auch möglich die zeitliche Abfolge mehrerer Bedienvorgänge zu erfassen. So kann mit dem erfindungsgemäßen Verfahren bestimmt werden, welche Elektroden in welcher Reihenfolge bzw. Richtung und mit welcher Geschwindigkeit bedient werden. Dies kann dann dazu verwendet werden, um zwischen verschiedenen Befehlen zu differenzieren, welche in Folge des Bedienvorganges auszuführen sind.

Eine besonders zuverlässige Weiterbildung des erfindungsgemäßen Verfahrens sieht vor, daß die ermittelten Parameter anhand der bekannten wechselseitigen Abhängigkeit auf ihre Plausibilität hin überprüft werden. Hierdurch können Fehler bei der Bestimmung der bedienten Sensorabschnitte wirksam vermieden werden. Ein solches Kriterium kann beispielsweise ein Dämpfungsmindest- oder Dämpfungshöchstwert sein, den die Kondensatoren bei der Betätigung eines bestimmten Sensorabschnitt nicht über- bzw. unterschreiten dürfen.

Weitere Vorteile der Erfindung sowie das technische Umfeld sind im Zusammenhang mit den nachfolgenden Ausführungsbeispielen und Figuren beschrieben. Es zeigen darin:
- **Fig. 1**: ein Kraftfahrzeug mit einer Ausführungsvariante der Sensoreinrichtung; und
- **Fig. 2**: eine schematische Darstellung einer erfindungsgemäßen Sensoreinrichtung.

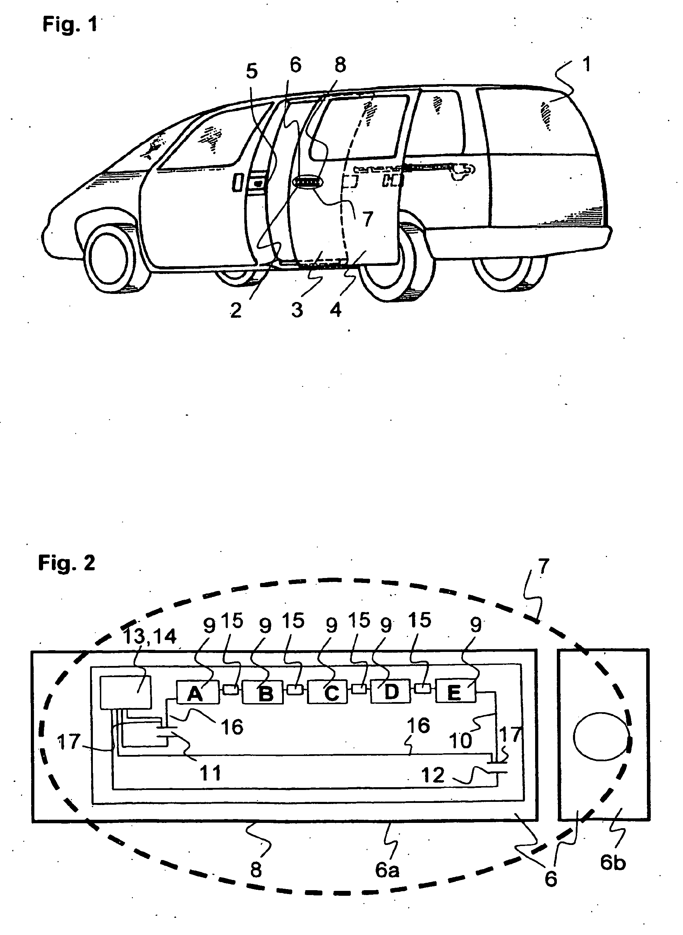

In Figur 1 ist ein Fahrzeug 1 dargestellt, welches mit einer erfindungsgemäßen Bedienstelle 2 ausgestattet ist. Die Bedienstelle 2 befindet sich an einer Außenseite 3 einer hinteren Schiebetür 4 und besteht aus einem Schließsystem 5 mit einem Türgriff 6, der im Bereich einer Griffmulde 7 am Fahrzeug 2 angeordnet ist. Der Türgriff 6 seinerseits ist mit einer erfindungsgemäßen Sensoreinrichtung 8 bestückt, die Betätigungen erfaßt.

In Figur 2 ist eine schematische Darstellung einer erfindungsgemäßen Sensoreinrichtung 8 aufgezeigt. Diese kann beispielsweise in dem Türgriff 6 des Fahrzeuges 1 oder in dessen Umgebung angeordnet sein. Der Türgriff 6 ist an der Griffmulde 7 positioniert, so daß er von einem Bediener leicht umfaßt werden kann. Bei dem dargestellten Ausführungsbeispiel besteht der Türgriff 6 aus einem Griff 6a und einem Schließzylinder 6b mit Gehäuse. Nach außen hin weist die Sensoreinrichtung 8 fünf im Griff 6a integrierte Sensorabschnitte 9 auf, die zur Eingabe von Befehlen oder Informationen dienen. Bei dem dargestellten Beispiel ist jedem der Sensorabschnitte 9 einer der Buchstaben A bis E zugeordnet. Den Buchstaben können je nach Bedarf Funktionen, etwa des Fahrzeuges 1 im Allgemeinen oder des Schließsystems 5, zugewiesen sein. Alternativ ist es auch möglich beliebige Codes und Zahlenkombinationen über die Sensorabschnitte 9 in bestimmter Reihenfolge einzugeben.

Hierzu sind die Sensorabschnitt 9 in einer Reihenschaltung 10 miteinander verbunden. Ebenfalls in der Reihenschaltung 10 umfaßt, sind zwei kapazitive Bauteile 11,12. Diese bilden ein erstes 11 und ein zweites 12 kapazitives Bauteil, das bei dem dargestellten Beispiel jeweils als Kondensatoren ausgebildet ist. Das erste kapazitive Bauteil 11 ist vor einem ersten Sensorabschnitt 9 mit dem Buchstaben A angeordnet, während sich das zweite kapazitive Bauteil 12 in der Reihenschaltung 10 hinter dem letzten Sensorabschnitt 9 mit dem Buchstaben E befindet. Weiterhin ist noch eine Steuerungseinrichtung 13 in Form einer Auswerteeinheit 14 in die Reihenschaltung 10 eingeschlossen, die als Auswerteschaltung ausgeführt ist. Ebenfalls in die Reihenschaltung 10 integriert sind elektrische Widerstände 15, welche sich jeweils zwischen den Sensorabschnitten 9 befinden. Die Auswerteeinrichtung 14 verfügt zusätzlich über elektrische Leiter 16, mit denen sie an eine jeweilige zweite elektrische Anschlußstelle 17 der kapazitiven Bauteile 11 und 12 angeschlossen ist. Während der Funktion der Sensoreinrichtung 8, überwacht die Auswerteeinrichtung 14 das kapazitive Verhalten der kapazitiven Bauteile 11 und 12. Hierzu kann als aussagekräftiger Parameter beispielsweise das Dämpfungsverhalten der beiden kapazitiven Bauteile 11 und 12 herangezogen und beobachtet werden.

Berührt nun ein Bediener beispielsweise den linken Sensorabschnitt 9 mit dem Buchstaben A, so verändern sich die Eigenschaften der beiden kapazitiven Bauteile 11 und 12. Das kapazitive Bauteil 11 erfährt dabei eine größere Dämpfung als das weiter entfernt angeordnete kapazitive Bauteil 12. Ein dazu genau umgekehrter Effekt tritt ein, wenn der Bediener den Sensorabschnitt 9 mit dem Buchstaben E drückt. In diesem Fall erfährt das kapazitive Bauteil 12 die höhere Dämpfung. Entsprechend abgestufte Dämpfungswerte können ermittelt werden, wenn die dazwischen liegenden Sensorabschnitte 9 mit den Buchstaben B, C und D berührt werden. Anhand des Dämpfungsverhaltens der kapazitiven Bauteile 11 und 12 kann die Auswerteeinrichtung 14 somit auf.den jeweils betätigten Sensorabschnitt 9 rückschließen. Es kann sogar erkannt werden, ob die Sensorabschnitte 9 durch einen Bediener von links nach rechts oder in umgekehrter Richtung überstrichen werden und mit welcher Geschwindigkeit dies erfolgte. Das Maß der Dämpfungsänderung steigt dabei mit den Widerstandswerten der Widerstände 15 an. Wie ersichtlich ist und zuvor auch bereits beschrieben worden ist, stehen die kapazitiven Bauteile 11 und 12 innerhalb der Reihenschaltung 10 zueinander in einer wechselseitigen Abhängigkeit. Diese Abhängigkeit wird bei der gezeigten Ausführungsform dazu genutzt die Erkennungssicherheit von Bedienungs- bzw. Eingabevorgängen zu erhöhen. Dies wird erreicht indem zur Erkennung eines Bedienvorgangs, etwa des Sensorabschnitts 9 mit dem Buchstaben A zwei Bedingungen erfüllt sein müssen. Ersten muss das kapazitive Bauteil 11 eine hohe Dämpfung aufweisen und zweitens muss das kapazitive Bauteil 12 eine geringe Dämpfung aufweisen. Durch die gleichzeitige Abfrage von zwei Bedingungen werden Fehlerkennungen wirksam vermieden. Daneben ist auch erkennbar, dass die erfindungsgemäße Sensoreinrichtung 9 im Wesentlichen aus einer besonders einfachen Reihenschaltung 10 aufgebaut ist, welche kostengünstig auch mit einer Vielzahl von Sensorabschnitten 9 herstellbar ist. Neben den elektrischen Leitern zur Bildung der Reihenschaltung 10 sind lediglich die Leiter 16 erforderlich, um die Steuerungseinrichtung 13 bzw. eine Auswerteeinheit 14 zusätzlich mit der zweiten Anschlußstelle 17 der kapazitiven Bauteile 11 und 12 zu verbinden.

Im Übrigen wird darauf hingewiesen, daß die vorliegende Erfindung nicht auf die dargestellten Ausführungsbeispielen beschränkt ist. Im Rahmen der Patentansprüche sind viel mehr zahlreiche Abwandlungen der Erfindung möglich. So können beispielsweise anstelle der beschriebenen Elektroden auch Folientastaturen oder sonstige Kontaktschalter zur Anwendung kommen, welche geeignet sind, das Dämpfungsverhalten der kapazitiven Bauteile 11 und 12 zu verändern. Neben den beschriebenen Ausführungsformen mit zwei kapazitiven Bauteilen 11 und 12 sind auch Formen mit drei und mehr kapazitiven Bauteilen möglich, die dann zusätzliche Informationen und Kriterien für die Auswerteeinrichtung 14 liefern.

### Bezugszeichenliste

- 1: Fahrzeug
- 2: Bedienstelle
- 3: Außenseite
- 4: Schiebetür
- 5: Schließsystem
- 6: Türgriff
- 6a: Griff
- 6b: Schließzylinder
- 7: Griffmulde
- 8: Sensoreinrichtung
- 9: Sensorabschnitt
- 10: Reihenschaltung
- 11: erstes kapazitives Bauteil
- 12: zweites kapazitives Bauteil
- 13: Steuerungseinrichtung
- 14: Auswerteeinrichtung
- 15: elektrischer Widerstand
- 16: Leiter
- 17: zweite Anschlußstelle

## Patentansprüche

1. Sensoreinrichtung (8) für Fahrzeuge (1), insbesondere zum Einsatz in Bedieneinrichtungen (6) von Kraftfahrzeugen (1), mit einer Mehrzahl von Sensorabschnitten (9), **dadurch gekennzeichnet, dass** die Sensorabschnitte (9) an Bedienstellen (2) des Fahrzeuges (1) angeordnet sind, wobei die Sensorabschnitte (9) in einer elektrische Reihenschaltung (10) miteinander verbunden sind und in dieser Reihenschaltung (10) zusätzlich wenigstens zwei kapazitive Bauteile (11,12) angeordnet sind, zwischen denen sich wenigstens ein Sensorabschnitt (9) befindet.

2. Sensoreinrichtung (8) nach dem vorhergehenden Anspruch, die an eine Steuerungseinrichtung (13) angeschlossen ist.

3. Sensoreinrichtung (8) nach einem der vorhergehenden Ansprüche, bei der die Sensorabschnitte (9) als Elektroden ausgebildet sind.

4. Sensoreinrichtung (8) nach einem der vorhergehenden Ansprüche, bei der zwischen den Sensorabschnitten (9) wenigsten ein elektrischer Widerstand (15) angeordnet ist.

5. Sensoreinrichtung (8) nach einem der vorhergehenden Ansprüche, bei der die kapazitiven Bauteile (11,12) Kondensatoren sind.

6. Sensoreinrichtung (8) nach einem der vorhergehenden Ansprüche, bei der die Steuerungseinrichtung (13) zusätzlich mit den zweiten elektrischen Anschlußstellen (17) der verwendeten kapazitiven Bauteile (11,12) verbunden ist.

7. Sensoreinrichtung (8) nach einem der vorhergehenden Ansprüche, bei der diese im Bereiche eines Schließsystems (5) eines Fahrzeuges (1) angeordnet ist.

8. Sensoreinrichtung (8) nach einem der vorhergehenden Ansprüche, bei der diese in einem Fahrzeuginnenraum an einer Bedienstelle (2) von Interieurfunktionen angeordnet ist.

9. Verfahren zum Erkennen von Signaleingaben an Fahrzeugen (1), umfassend zumindest folgende Schritte:
a) Herstellung einer wechselseitigen Abhängigkeit zwischen zwei kapazitiven Bauteilen (11,12) mittels Sensorabschnitten (9);
b) Überwachung wenigstens eines Parameters der in Abhängigkeit stehenden kapazitiven Bauteile (11,12) mittels einer Steuerungseinrichtung (13); .
c) Ermittlung einer Signaleingabe aus jeweils zwei in wechselseitiger Abhängigkeit stehenden Parametern, wobei bestimmten Parameterkombinationen oder Gruppen von Parameterkombinationen jeweils definierte Signaleingaben zugewiesen werden.

10. Verfahren nach dem vorhergehenden Anspruch, bei dem die ermittelten Parameter anhand der bekannten wechselseitigen Abhängigkeit auf ihre Plausibilität hin überprüft werden.

## Claims

1. Sensor arrangement (8) for vehicles (1), in particular for use in operating arrangements (6) of motor vehicles (1), with a plurality of sensor sections (9) which are connected with each other in an electric series connection (10), **characterized in that** the sensor sections (9) are arranged at operating sites (2) of the vehicle (1) and in this series connection (10) additionally at least two capacitive components (11, 12) are arranged, between which at least one sensor section (9) is situated.

2. Sensor arrangement (8) according to the preceding claim, which is connected to a control arrangement (13).

3. Sensor arrangement (8) according to one of the preceding claims, in which the sensor sections (9) are constructed as electrodes.

4. Sensor arrangement (8) according to one of the preceding claims, in which at least one electric resistor (15) is arranged between the sensor sections (9).

5. Sensor arrangement (8) according to one of the preceding claims, in which the capacitive components (11, 12) are capacitors.

6. Sensor arrangement (8) according to one of the preceding claims, in which the control arrangement (13) is additionally connected with the second electric connection sites (17) of the capacitive components (11, 12) which are used.

7. Sensor arrangement (8) according to one of the preceding claims, in which this is arranged in the region of a locking system (5) of a vehicle (1).

8. Sensor arrangement (8) according to one of the preceding claims, in which this is arranged in a vehicle interior at an operating site (2) of interior functions.

9. Method for detecting signal inputs in vehicles (1), comprising at least the following steps:
a) Production of a reciprocal dependence between two capacitive components (11, 12) by means of sensor sections (9);
b) Monitoring at least of one parameter of the capacitive components (11, 12) which are in dependence, by means of a control arrangement (13);
c) Determining a signal input from respectively two parameters in reciprocal dependence, wherein defined signal inputs are assigned respectively to particular parameter combinations or groups of parameter combinations.

10. Method according to the preceding claim, in which the determined parameters are examined with respect to their plausibility by means of the known reciprocal dependence.

## Revendications

1. Dispositif capteur (8) pour véhicules (1), en particulier pour une utilisation dans des dispositifs de commande (6) de véhicules (1), présentant une pluralité de parties de capteur (9), qui sont reliées les unes aux autres dans un montage en série (10) électrique, **caractérisé en ce que** les parties de capteur (9) sont disposées en des points de commande (2) du véhicule (1) et en supplément au moins deux composants (11, 12) capacitifs sont disposés dans ce montage en série (10), composants entre lesquels se trouve une partie de capteur (9).

2. Dispositif capteur (8) selon la revendication précédente, qui est raccordé à un dispositif de commande (13).

3. Dispositif capteur (8) selon l'une quelconque des revendications précédentes, sur lequel les parties de capteur (9) sont conçues sous forme d'électrodes.

4. Dispositif capteur (8) selon l'une quelconque des revendications précédentes, sur lequel au moins une résistance (15) électrique est disposée entre les parties de capteur (9).

5. Dispositif capteur (8) selon l'une quelconque des revendications précédentes, sur lequel les composants (11, 12) capacitifs sont des condensateurs.

6. Dispositif capteur (8) selon l'une quelconque des revendications précédentes, sur lequel le dispositif de commande (13) est relié en supplément aux seconds points de branchement (17) électriques des composants (11, 12) capacitifs utilisés.

7. Dispositif capteur (8) selon l'une quelconque des revendications précédentes, sur lequel celui-ci est disposé dans la zone d'un système de fermeture (5) d'un véhicule (1).

8. Dispositif capteur (8) selon l'une quelconque des revendications précédentes, sur lequel celui-ci est disposé dans un intérieur de véhicule en un point de commande (2) de fonctions d'intérieur.

9. Procédé pour identifier des entrées de signaux sur des véhicules (1), comprenant au moins les étapes suivantes :
a) établissement d'une dépendance réciproque entre deux composants (11, 12) capacitifs au moyen de parties de capteur (9) ;
b) contrôle d'au moins un paramètre des composants (11, 12) capacitifs en dépendance au moyen d'un dispositif de commande (13) ;
c) détermination d'une entrée de signal à partir de respectivement deux paramètres mis en dépendance réciproque, des entrées de signaux respectivement définies étant attribuées à chaque fois à des combinaisons de paramètres définies ou des groupes définis de combinaisons de paramètres.

10. Procédé selon la revendication précédente, sur lequel les paramètres déterminés sont contrôlés au niveau de leur vraisemblance à l'aide de la dépendance réciproque connue.
